# EUROPÄISCHE PATENTANMELDUNG

(11) **EP 1 278 283 A2**
(43) Veröffentlichungstag der Anmeldung: **22.01.2003**
(21) Anmeldenummer: 02012521.7
(22) Anmeldetag: 05.06.2002
(51) Int. Cl.: H02H 9/04

(54) **Vorrichtung zum Schutz elektronischer Bauelemente**

(30) Priorität: 19.07.2001 DE 10135168
(71) Anmelder: ROBERT BOSCH GMBH, 70442 Stuttgart (DE)
(72) Erfinder: Heinisch, 72760 Reutlingen (DE); Topp, Rainer, 72768 Reutlingen (DE); Jacob, Wolfgang, 72160 Horb (DE); Krauss, Hans-Reiner, Dr., 72762 Reutlingen (DE)

(57) **Zusammenfassung**

Die Erfindung schafft eine Vorrichtung 1 zum Schutz elektronischer Bauelemente vor Überspannungen der Netzspannung V_{Gen}, mit mindestens einem Halbleiter-Transistor 2, der mittels einer Ansteuerschaltung 3 bei vorbestimmten Überspannungswerten durchschaltbar ist, wodurch eine Umwandlung elektrischer Energie in Wärmeenergie erfolgt.

## Beschreibung

### STAND DER TECHNIK

Die vorliegende Erfindung betrifft eine Vorrichtung zum Schutz elektronischer Bauelemente vor Überspannungen der Netzspannung.

Obwohl auf beliebige elektrische Versorgungsschaltungen anwendbar, werden die vorliegende Erfindung sowie die ihr zugrundeliegende Problematik in Bezug auf eine elektronische Anlage eines Kraftfahrzeuges erläutert.

Es ist allgemein bekannt, dass bei induktiven Lasten, wie Spulen oder dergleichen, direkt oder indirekt Überspannungen induziert werden. Eine besonders schädigende Überspannung entsteht beispielsweise bei einem schlechten Kontakt oder einer augenblicklichen Trennung der Batterie im Betrieb des Generators (Load-Dump). Beispielsweise können im Kraftfahrzeugbereich bei einer Versorgungsspannung von 12 V Überspannungen bis zu 80 V in einem Zeitraum von 400 ms auftreten. Diese Transienten können verschiedene elektronische Schaltungen, beispielsweise integrierte Schaltungen im Kraftfahrzeug zerstören, falls diese nicht wirksam gegen solche Überspannungen geschützt sind.

Es besteht die Möglichkeit, einer Zerstörung der elektronischen Bauelemente durch Überspannungen des Bordnetzes eines Kraftfahrzeuges dadurch entgegenzuwirken, dass die entsprechenden Bauelemente jeweils entsprechend den maximal auftretenden Spannungsspitzen ausgelegt werden. Dies ist allerdings äußerst kostenaufwendig und nicht rentabel.

Die der vorliegenden Erfindung zugrundeliegende Problematik besteht also allgemein darin, eine Schutzvorrichtung zu schaffen, die für einen normalen Betrieb ausgelegte Bauelemente vor Überspannungen der Netzspannung des Generators schützen soll.

Es ist der Anmelderin bekannt, Zener-Dioden in Verbindung mit dem Generator zu verwenden, die auch bei großen Stromänderungen lediglich eine geringe Spannungsänderung ermöglichen.

Als nachteilig bei diesem bekannten Ansatz hat sich die Tatsache herausgestellt, dass die an der Zener-Diode anliegende Spannung einen großen Toleranzbereich aufweist und erheblich von der an dem Bauelement anliegenden Temperatur abhängig ist. Bei einem Übergang zu beispielsweise einer höheren Kraftfahrzeug-Bordspannung (wie serienmäßig bereits in Planung) werden somit diese Toleranz- und diese Temperaturabhängigkeit zu groß für eine sinnvolle Anwendung.

### VORTEILE DER ERFINDUNG

Die erfindungsgemäße Vorrichtung mit den Merkmalen des Anspruchs 1 weist gegenüber den bekannten Lösungsansätzen den Vorteil auf, dass sie für große Bordnetzspannungen geeignet und preisgünstig herstellbar ist, sowie dass eine verpolfeste Ausrichtung der Vorrichtung möglich ist. Ferner besitzt die Vorrichtung eine geringe Toleranz und einen geringen Temperaturkoeffizienten der Ansprechschwelle.

Die der vorliegenden Erfindung zugrundeliegende Idee besteht darin, dass die Vorrichtung zum Schutz elektronischer Bauelemente vor Überspannungen der Netzspannung mindestens einen Halbleiter-Transistor aufweist, der mittels einer Ansteuerschaltung bei vorbestimmten Überspannungswerten durchschaltbar ist, wodurch eine Umwandlung elektrischer Energie in Wärmeenergie erfolgt.

Durch das definierte Schalten der Überspannungen der Netzspannung über den mindestens einen Halbleiter-Transistor wird die Load-Dump-Energie durch das Halbleiter-Bauelement und den Innenwiderstand der Netzspannungsquelle in Wärme umgewandelt, wodurch die angeschlossenen elektronischen Bauelemente vor einer Schädigung durch die ursprüngliche Load-Dump-Energie geschützt werden.

In den Unteransprüchen finden sich vorteilhafte Weiterbildungen und Verbesserungen der in Anspruch 1 angegebenen Schutzvorrichtung.

Gemäß einer bevorzugten Weiterbildung sind die Ansteuerschaltung und der Halbleiter-Transistor als integrierte Schaltungen auf einem gemeinsamen Chip vorgesehen.

Gemäß einer weiteren bevorzugten Weiterbildung ist der Halbleiter-Transistor mit einer Zener-Diode seriell elektrisch verbindbar. Die Zener-Diode dient neben einer Spannungsstabilisierung ebenfalls einer Umwandlung elektrischer Energie der Überspannung in Wärmeenergie.

Gemäß einer weiteren bevorzugten Weiterbildung sind der Halbleiter-Transistor und die Zener-Diode als integrierte Schaltungen auf zwei voneinander getrennten Chips vorgesehen. Dabei können die beiden Chips sowohl stapelförmig als auch nebeneinander angeordnet und in an sich bekannter Weise miteinander elektrisch verbunden werden.

Gemäß einer weiteren bevorzugten Weiterbildung ist die Vorrichtung zumindest teilweise von mindestens einer Wärmeableitungseinrichtung umgeben. Die in den Halbleiter-Bauelementen erzeugte Wärme kann somit von den Bauelementen abgeführt und gegebenenfalls an die Umgebung abgegeben werden.

Gemäß einer weiteren bevorzugten Weiterbildung ist mindestens eine Wärmeableitungseinrichtung als Metallkörper, Vergussmasse, beispielsweise Epoxidmasse, und/oder als Metallbecher ausgebildet. Entscheidend ist lediglich, dass ein direkter Kontakt zwischen der bzw. den Wärmeableitungseinrichtungen und den entsprechenden Halbleiter-Bauelementen existiert.

Gemäß einer weiteren bevorzugten Weiterbildung ist der Halbleiter-Transistor als MOSFET-Transistor, insbesondere als vertikaler Power-MOSFET-Transistor, mit integrierter Ansteuerschaltung ausgebildet.

Gemäß einer weiteren bevorzugten Weiterbildung ist der Halbleiter-Transistor als vertikaler Bipolar-Transistor mit integrierter Ansteuerschaltung ausgebildet.

Gemäß einer weiteren bevorzugten Weiterbildung sind die elektrischen Verbindungen der Vorrichtung als Lötverbindungen und/oder Direct-Die-Bonding Verbindungen ausgebildet.

Gemäß einer weiteren bevorzugten Weiterbildung ist die Zener-Diode mit einer Gleichrichterdiode seriell geschaltet. Dadurch kann eine Zerstörung des Bauelementes im Falle einer Verpolung beispielsweise durch Verwendung eines n⁺-p-n-Halbleiter-Bauelementes vermieden werden.

Gemäß einer weiteren bevorzugten Weiterbildung sind die Zener-Diode und die Gleichrichterdiode in einem 3-Schicht-Halbleiterelement integriert.

Gemäß einer weiteren bevorzugten Weiterbildung ist die Vorrichtung in einer elektronischen Anlage eines Kraftfahrzeuges zum Schutz der Bauelemente der Anlage vor Überspannungen des Kraftfahrzeug-Bordnetzes vorgesehen.

### ZEICHNUNGEN

Ausführungsbeispiele der Erfindung sind in den Zeichnungen dargestellt und in der nachfolgenden Beschreibung näher erläutert.

Von den Figuren zeigen:
- Fig. 1a: ein Schaltbild der Vorrichtung gemäß einem ersten Ausführungsbeispiel der vorliegenden Erfindung;
- Fig. 1b: ein Schaltbild der Vorrichtung gemäß einem zweiten Ausführungsbeispiel der vorliegenden Erfindung;
- Fig. 1c: ein Schaltbild der Vorrichtung gemäß einem dritten Ausführungsbeispiel der vorliegenden Erfindung;
- Fig. 2: detaillierteres Schaltbild der Vorrichtung gemäß dem ersten Ausführungsbeispiel in Fig. 1a;
- Fig. 3a: ein Schaltbild einer Serienschaltung einer Zener-Diode und einer Gleichrichterdiode;
- Fig. 3b: eine schematische Querschnittsansicht der Gleichrichterdiode in Fig. 3a;
- Fig. 4a: eine schematische Darstellung der Vorrichtung mit Wärmeableitungseinrichtungen gemäß dem dritten Ausführungsbeispiel in Fig. 1c;
- Fig. 4b: eine schematische Darstellung einer weiteren geometrischen Anordnung der Vorrichtung in Verbindung mit Wärmeableitungseinrichtungen gemäß dem dritten Ausführungsbeispiel in Fig. 1c;
- Fig. 5: eine schematische Querschnittsansicht der geometrischen Anordnung einer Vorrichtung mit Wärmeableitungseinrichtungen gemäß dem ersten oder zweiten Ausführungsbeispiel Fig. 1a bzw. 1b; und
- Fig. 6: eine schematische Querschnittsansicht einer weiteren geometrischen Anordnung der Vorrichtung mit Wärmeableitungseinrichtungen gemäß dem ersten oder zweiten Ausführungsbeispiel in Fig. 1a bzw. 1b.

### BESCHREIBUNG DER AUSFÜHRUNGSBEISPIELE

In den Figuren bezeichnen gleiche Bezugszeichen gleiche oder funktionsgleiche Komponenten.

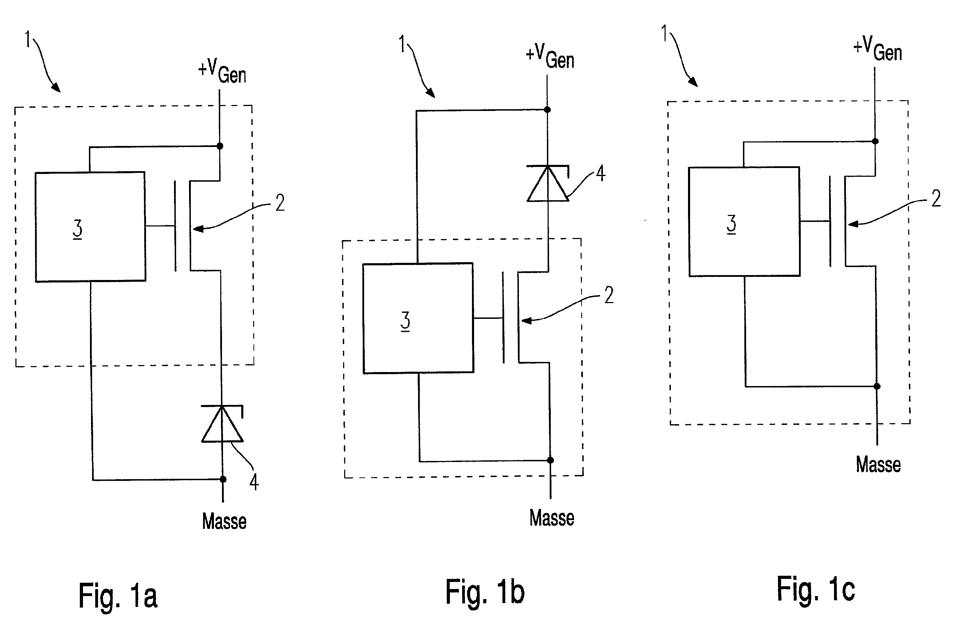

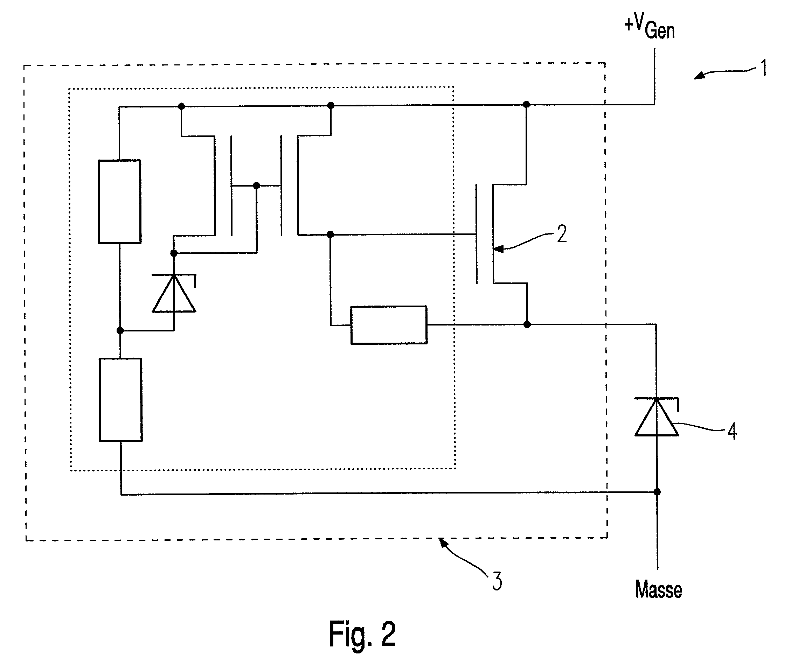

Die Figuren 1a und 2 illustrieren ein Blockschaltbild einer möglichen Schaltungsvariante einer Vorrichtung 1 zum Schutz elektronischer Bauelemente vor Überspannungen der Generatorspannung V_{Gen} gemäß einem ersten Ausführungsbeispiel der vorliegenden Erfindung.

Vorteilhaft ist ein vertikaler Power-MOSFET-Transistor 2 mit der Versorgungsspannungsquelle V_{Gen} elektrisch verbunden, wobei eine Ansteuerschaltung 3 an der Versorgungsspannungsquelle V_{Gen} und dem MOSFET-Transistor 2 angeschlossen ist. Die Ansteuerschaltung 3 ist in Fig. 2 detaillierter dargestellt, wobei sie bei einem vorbestimmten Spannungswert der Überspannung der Spannungsquelle V_{Gen} den MOSFET-Transistor 2 aktiviert bzw. durchgeschaltet.

Zusätzlich ist vorteilhaft eine Zener-Diode 4 seriell mit dem MOSFET-Transistor 2 geschaltet. Somit wird bei einer Ansteuerung des MOSFET-Transistors 2 durch die Ansteuerschaltung 3 im Falle eines vorbestimmten Überspannungswertes gemäß dem ersten Ausführungsbeispiel elektrische Energie der Überspannung (Load-Dump-Energie) durch die Halbleiter-Bauelemente 2, 4 und den Innenwiderstand der Spannungsquelle V_{Gen} aufgrund des Stromdurchflusses in Wärmeenergie umgewandelt und gegebenenfalls an die Umgebung abgegeben.

Fig. 1b zeigt ein Blockschaltbild einer Schaltung der Vorrichtung 1 gemäß einem zweiten Ausführungsbeispiel der vorliegenden Erfindung. Im Unterschied zum ersten Ausführungsbeispiel ist die zusätzliche Zener-Diode 4 seriell zwischen die Spannungsquelle V_{Gen} und den MOSFET-Transistor 2 geschaltet. Die Reduzierung der Überspannungsenergie bzw. die Energieumwandlung erfolgt analog dem oben beschriebenen ersten Ausführungsbeispiel.

In Fig. 1c ist ein Blockschaltbild einer Schaltung der Vorrichtung 1 gemäß einem dritten Ausführungsbeispiel der vorliegenden Erfindung dargestellt, wobei auf die seriell geschaltete Zener-Diode 4 verzichtet wird und lediglich das Halbleiter-Bauelement 2 als Energieumwandlungsbauelement bei einer Ansteuerung mittels der Ansteuerschaltung 3 dient.

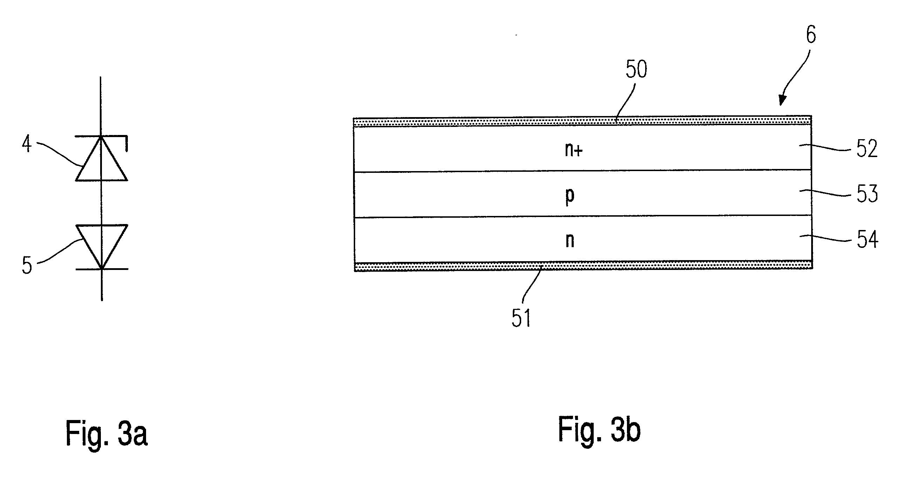

Für eine Vermeidung einer Zerstörung der Zener-Diode 4 beim ersten und zweiten Ausführungsbeispiel gemäß den Figuren 1a und 1b wird vorteilhaft die Zener-Diode 4 mit einer Gleichrichterdiode 5 in Serie geschaltet, wie in Fig. 3a ersichtlich. Dabei ist die Gleichrichterdiode 5 vorteilhaft als Schichtstruktur, bestehend aus einer n⁺-dotierten Schicht 52, einer p-dotierten Schicht 53 und einer n-dotierten Schicht 54 zusammengebaut und über zwei Metallisierungsschichten 50, 51 ansteuerbar.

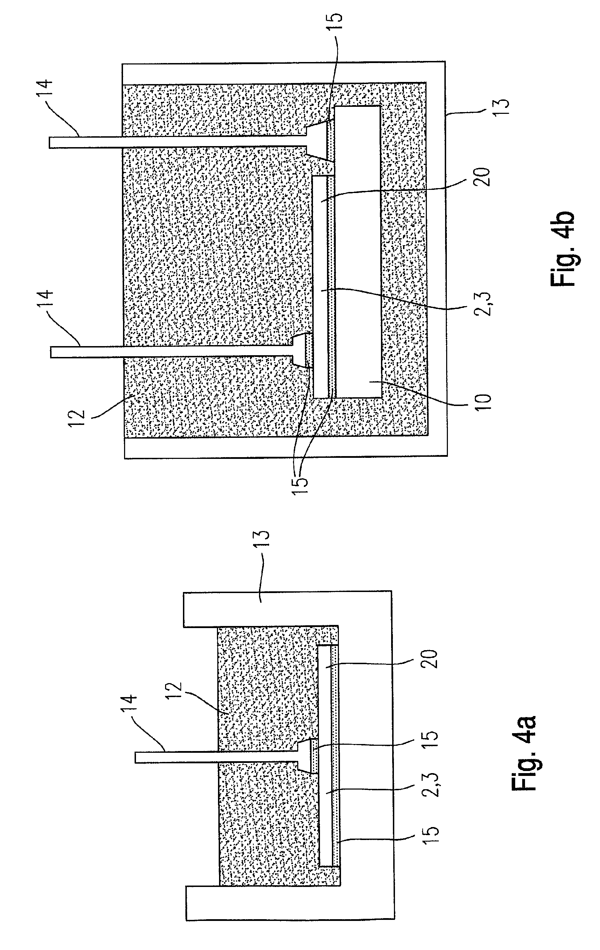

Die Figuren 4a und 4b zeigen zwei verschiedene geometrische Ausführungsformen der Schutzvorrichtung 1 gemäß dem dritten Ausführungsbeispiel nach Fig. 1c, wobei die Ansteuerschaltung 3 und der MOSFET-Transistor 2 vorteilhaft auf einem gemeinsamen Chip 20 integriert sind.

In Fig. 4a ist der Chip 20, auf dem die Ansteuerschaltung 3 und der MOSFET-Transistor 2 integriert sind, für eine Ableitung der in dem Halbleiter-Bauelement erzeugten Wärme in einem Behälter 13, vorteilhaft einem gut leitenden Metallbecher 13, angeordnet. Dabei ist der Chip 20 über Lotverbindungen 15 mit dem Metallbecher 13 und Anschlussdrähten 14 verbunden. Zusätzlich ist eine Vergussmasse 12, vorteilhaft eine Epoxidmasse, in dem Metallbecher 13 für eine Wärmeableitung angeordnet und mit dem Chip 20 in Kontakt.

Fig. 4b zeigt eine weitere Ausführungsform einer Ein-Chip-Lösung, bei der die Ansteuerschaltung 3 und der MOSFET-Transistor 2 auf dem selben Chip 20 integriert sind. Der Chip 20 ist an der Unterseite über eine Lotverbindung 15 mit einem gut wärmeleitfähigen Metallkörper 10, beispielsweise einer Metallplatte 10, thermisch in Kontakt.

Anschlussdrähte 14 sind wiederum über Lotverbindungen 15 an den entsprechenden Bauteilen befestigt.

Diese Anordnung ist vollständig von einer Vergussmasse 12 umgeben, welche vorteilhaft in einem Metallbecher 13 angeordnet ist. Dadurch ist ebenfalls eine gute thermische Wärmeabgabe des Halbleiter-Bauelementes an die diesen umgebenden Materialien bzw. an die Umgebung gewährleistet.

Die Chips 20 besitzen lötfähige Metallisierungen vorteilhaft sowohl auf der Vorder- als auch auf der Rückseite für eine Lötverbindung mit Anschlussdrähten 14.

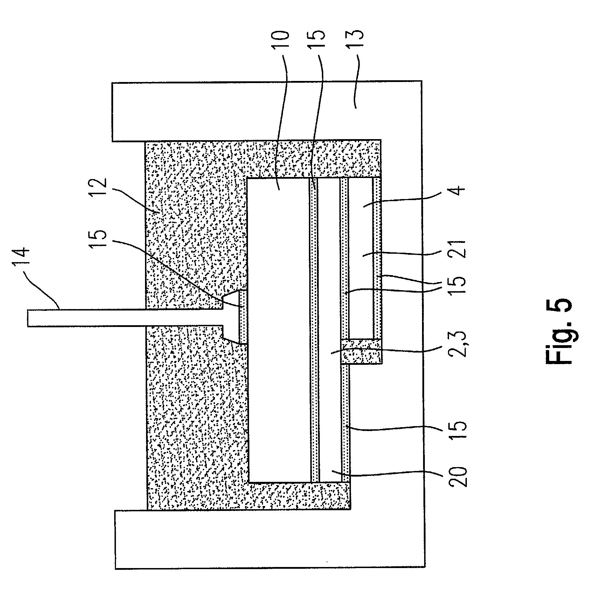

Fig. 5 illustriert eine schematische Querschnittsansicht einer erfindungsgemäßen Vorrichtung gemäß dem ersten oder zweiten Ausführungsbeispiel in Fig. 1a bzw. Fig. 1b der vorliegenden Erfindung.

Bei diesem Ausführungsbeispiel ist die Vorrichtung als Zwei-Chip-Lösung ausgebildet, d.h. die Ansteuerschaltung 3 zusammen mit dem MOSFET-Transistor 2 befinden sich auf einem Chip 20 und die zusätzliche Zener-Diode 4 ist in einem zusätzlichen, eigenen Chip 21 integriert.

In diesem Ausführungsbeispiel sind die beiden Chips 20, 21 stapelförmig zueinander aufgebaut, wobei über Lotverbindungen 15 die entsprechenden elektrischen Verbindungen zwischen den Chips 20, 21 hergestellt werden. Gegebenenfalls können die Halbleiterchips 20, 21 auch durch Direct-Die-Bonding miteinander verbunden werden.

Für eine Ableitung der in den Halbleiterbauelementen 2, 4 erzeugten Wärme ist beispielsweise der Chip 20 an der Oberseite mit einem Metallkörper 10 und an den freien Flächen der Unterseite mit einem Metallbecher 13 thermisch verbunden.

Der Chip 21 kontaktiert ebenfalls für eine Wärmeabgabe an der Unterseite den Metallbecher 13. Ferner ist die Anordnung im Inneren des Metallbechers 13 von einer Vergussmasse 12 umgeben.

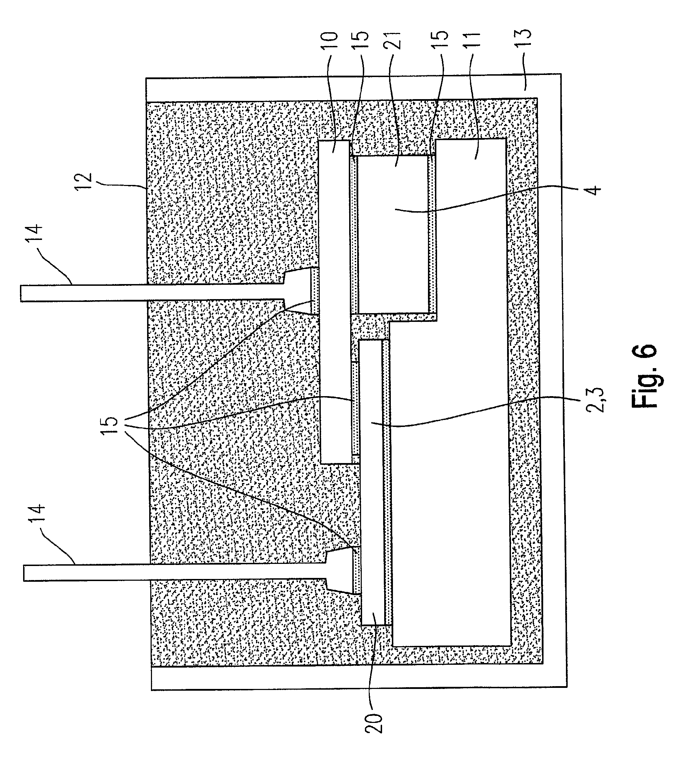

Eine weitere Ausführungsform der Zwei-Chip-Lösung ist in Fig. 6 dargestellt. Wiederum sind die Ansteuerschaltung 3/der MOSFET-Transistor 2 sowie die zusätzliche Zener-Diode 4 auf zwei voneinander mechanisch getrennten Chips 20, 21 angebracht bzw. integriert. Die beiden Chips 20, 21 sind in dem Ausführungsbeispiel gemäß Fig. 6 nebeneinander auf einem entsprechend geformten Metallkörper 11 montiert und vorteilhaft über Lotverbindungen 15 oder direkt durch Direct-Die-Bonding miteinander verbunden. An der Oberfläche der beiden Chips 20, 21 ist ebenfalls ein entsprechend geformter Metallkörper 10, vorteilhaft eine Metallplatte, für eine Wärmeabfuhr vorgesehen. Die soeben beschriebene Vorrichtung ist von einer Vergussmasse 12 umgeben und befindet sich wiederum in einem Metallbecher 13, über den die abgeführte Wärme an die Umgebung abgegeben wird.

Auch bei der Zwei-Chip-Lösung sind Anschlussdrähte 14 vorteilhaft über Lotverbindungen 15 für eine elektrische Verbindung an den Chips bzw. Metallplatten angelötet.

Die Schutzvorrichtung gemäß der vorliegenden Erfindung ist im Gegensatz zu den Lösungsansätzen nach dem Stand der Technik auch bei höheren Kraftfahrzeug-Bordnetzspannungen einsetzbar. Zudem ist diese Vorrichtung kostengünstig herstellbar, aufgrund des kompakten, zweipoligen Bauelementes einfach montierbar und thermisch von einem Gleichrichter entkoppelbar.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

Beispielsweise ist eine Zwei-Chip-Lösung auch derart realisierbar, dass der Power-MOSFET-Transistor 2 und die Ansteuerschaltung 3 auf voneinander mechanisch getrennten Chips integriert sind. In Abhängigkeit von den Kosten für die Herstellung des Power-MOSFET-Transistors und den Kosten für die Montage ist entweder die Ein-Chip-Lösung (Power-MOSFET-Transistor mit Ansteuerschaltung), eine Zwei-Chip-Lösung (Power-MOSFET-Transistor mit Ansteuerschaltung und Zener-Diode oder Power-MOSFET-Transistor und Ansteuerschaltung auf voneinander getrennten Chips) oder die Drei-Chip-Lösung (Power-MOSFET-Transistor, Ansteuerschaltung und Zener-Diode auf voneinander getrennten Chips) preisgünstiger zu fertigen.

### BEZUGSZEICHENLISTE

| | |
|---|---|
| 1 | Schutzvorrichtung |
| 2 | MOSFET-Transistor |
| 3 | Ansteuerschaltung |
| 4 | Zener-Diode |
| 5 | Gleichrichterdiode |
| 6 | 3-Schicht-Halbleiterelement |
| 10 | Metallkörper |
| 11 | Metallkörper |
| 12 | Vergussmasse |
| 13 | Metallbecher |
| 14 | Anschlussdraht |
| 15 | Elektrische Verbindung |
| 20 | Chip (erster) |
| 21 | Chip (zweiter) |
| 51 | Metallisierung |
| 52 | n⁺-Schicht |
| 53 | p-Schicht |
| 54 | n-Schicht |
| V_{Gen} | Generatorspannung / Netzspannung |

## Patentansprüche

1. Vorrichtung (1) zum Schutz elektronischer Bauelemente vor Überspannungen der Netzspannung (V_{Gen}),
**gekennzeichnet durch**
mindestens einen Halbleiter-Transistor (2), der mittels einer Ansteuerschaltung (3) bei vorbestimmten Überspannungswerten durchschaltbar ist, wodurch eine Umwandlung elektrischer Energie in Wärmeenergie erfolgt.

2. Schutzvorrichtung nach Anspruch 1, **dadurch gekennzeichnet, dass** die Ansteuerschaltung (3) und der Halbleiter-Transistor (2) als integrierte Schaltungen auf einem gemeinsamen Chip (20) vorgesehen sind.

3. Schutzvorrichtung nach einem der Ansprüche 1 oder 2, **dadurch gekennzeichnet, dass** der Halbleiter-Transistor (2) mit einer Zener-Diode (4) seriell verbindbar ist.

4. Schutzvorrichtung nach einem der vorhergehenden Ansprüche, **dadurch gekennzeichnet, dass** der Halbleiter-Transistor (2) und die Zener-Diode (4) als integrierte Schaltungen auf zwei einzelnen Chips (20, 21) vorgesehen sind.

5. Schutzvorrichtung nach Anspruch 4, **dadurch gekennzeichnet, dass** die zwei Chips (20, 21) stapelförmig oder nebeneinander angeordnet sind.

6. Schutzvorrichtung nach einem der vorhergehenden Ansprüche, **dadurch gekennzeichnet, dass** die Chips (20, 21) zumindest teilweise von mindestens einer Wärmeableitungseinrichtung (10, 11, 12, 13) umgeben sind.

7. Schutzvorrichtung nach Anspruch 6, **dadurch gekennzeichnet, dass** die mindestens eine Wärmeableitungseinrichtung (10, 11, 12, 13) als Metallkörper (10, 11), Vergußmasse (12), beispielsweise Epoxidmasse, und/oder als Metallbecher (13) ausgebildet ist.

8. Schutzvorrichtung nach einem der vorhergehenden Ansprüche, **dadurch gekennzeichnet, dass** der Halbleiter-Transistor (2) als MOSFET-Transistor (2), insbesondere als vertikaler Power-MOSFET-Transistor, mit integrierter Ansteuerschaltung ausgebildet ist.

9. Schutzvorrichtung nach einem der Ansprüche 1 bis 7, **dadurch gekennzeichnet, dass** der Halbleiter-Transistor (2) als vertikaler Bipolar-Transistor (2) mit integrierter Ansteuerschaltung ausgebildet ist.

10. Schutzvorrichtung nach einem der vorhergehenden Ansprüche, **dadurch gekennzeichnet, dass** die elektrischen Verbindungen (15) als Lötverbindungen und/oder Direct-Die-Bonding-Verbindungen ausgebildet sind.

11. Schutzvorrichtung nach einem der Ansprüche 3 bis 10, **dadurch gekennzeichnet, dass** die Zener-Diode (4) mit einer Gleichrichterdiode (5) seriell geschaltet ist.

12. Schutzvorrichtung nach Anspruch 11, **dadurch gekennzeichnet, dass** die Zener-Diode (4) und die Gleichrichterdiode (5) in einem 3-Schicht-Halbleiterelement (6) integriert sind.

13. Schutzvorrichtung nach einem der vorhergehenden Ansprüche, **dadurch gekennzeichnet, dass** die Vorrichtung (1) in einer elektronischen Anlage eines Kraftfahrzeuges zum Schutz der elektronischen Bauelemente der Anlage vor Überspannungen des Kraftfahrzeug-Bordnetzes vorgesehen ist.
